Europäisches Patentamt

European Patent Office

Office européen des brevets

(19)

(11)  **EP 0 712 223 A2**

(12)  # EUROPÄISCHE PATENTANMELDUNG

(43) Veröffentlichungstag:
**15.05.1996  Patentblatt 1996/20**

(51) Int. Cl.<sup>6</sup>: **H04L 25/49**

(21) Anmeldenummer: **95112291.0**

(22) Anmeldetag: **04.08.1995**

(84) Benannte Vertragsstaaten:
**AT CH DE DK ES FR GB IT LI**

(30) Priorität: **07.11.1994 DE 4439281**

(71) Anmelder: **ROBERT BOSCH GMBH**
**70442 Stuttgart (DE)**

(72) Erfinder:
- **Knittel, Dietmar**
  **D-01127 Dresden (DE)**
- **Abt, Andreas**
  **D-01817 Kamenz (DE)**
- **Tröller, Karsten**
  **D-09117 Chemnitz (DE)**
- **Schlenker, Andreas**
  **D-01454 Radeberg (DE)**

(54)  **Verfahren zur Übertragung digitaler Daten**

(57)  Zur Übertragung digitaler Daten mit unterschiedlicher Informationsdichte wird der Hauptkanal mit einem Blockcode gesichert. Der Zusatzkanal wird ungesichert übertragen und zum Schutz gegen Übertragungsfehler empfangsseitig einer Mehrfachentscheidung unterzogen.

Es läßt sich eine ausreichende Störsicherheit bei begrenztem Codieraufwand erreichen.

EP 0 712 223 A2

**Beschreibung**

Die Erfindung geht aus von einem Verfahren gemäß dem Oberbegriff des Patentanspruchs 1. Ein solches Verfahren ist bekannt aus der DE 40 20 963 A1.

Beim Verfahren gemäß der DE 40 20 963 A1 wird ein Zusatzkanal dadurch geschaffen, daß neben dem blockcodierten Hauptkanal der Zusatzkanal mit einem zweiten Blockcode getrennt codiert wird und der übertragene Datenstrom wechselweise aus den Blöcken des Hauptkanals und einem Bit des blockcodierten Zusatzkanals zusammengesetzt ist. Durch die Codierung mit mehreren Blockcodes ist ein hoher Codieraufwand insbesondere auch für die Daten des Zusatzkanals erforderlich. Bei einer Codierung mit nur einem Blockcode wäre zwar der Codieraufwand geringer, aber der Störabstand der Datenkanäle wäre geringer.

Aufgabe vorliegender Erfindung ist es, ein Verfahren ausgehend vom Oberbegriff des Patentanspruchs 1 anzugeben, das eine ausreichende Störsicherheit gegen Übertragungsfehler gewährleistet und einen begrenzten Codieraufwand besitzt. Diese Aufgabe wird durch die Schritte des Patentanspruchs 1 gelöst. Die Unteransprüche zeigen vorteilhafte Ausgestaltungen auf.

Die Erfindung basiert auf folgenden Erkenntnissen: Durch die Trennung der Informationskanäle nach ihrer Entropie, d.h. ihrer unterschiedlichen Informationsdichte, und der Anwendung verschiedener Codierverfahren, läßt sich eine gute Störsicherheit erreichen, ohne daß der Codieraufwand erhöht werden muß. Der Kanal mit hoher Informationsdichte kann mit einem linearen Blockcode durch Alphabetreduktion auf größte Minimaldistanz gesichert werden. Der Zusatzkanal/die Zusatzkanäle wird/werden ungesichert übertragen und empfangsseitig zum Schutz gegen Übertragungsfehler einer Mehrfachentscheidung, z.B. nach der Maximum-Likelihood-Methode (F.J. Furrer "Fehlerkorrigierende Block-Codierung für die Datenübertragung", Birkhäuser Verlag, Basel, 1981, Seiten 229 bis 237) unterzogen.

Im Gegensatz zur Codierung des Hauptkanals und des Zusatzkanals mit einem Blockcode läßt sich durch das erfindungsgemäße Verfahren ein höherer Störabstand erzielen. Gegenüber der Codierung mit mehreren Blockcodes reduziert sich der Codieraufwand.

Es ist mit dem Verfahren nach der Erfindung ein ausreichender Schutz gegen Einzelfehler und Bündelfehler gewährleistet.

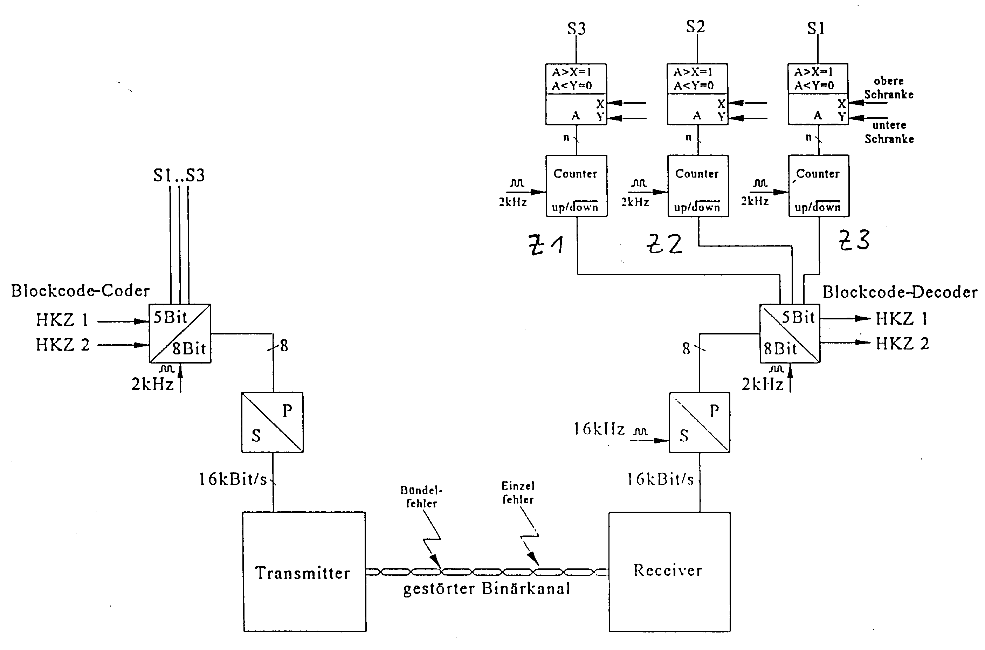

Anhand der Zeichnung werden Ausführungsbeispiele der Erfindung erläutert. Diese zeigt eine Funktionsskizze für eine Übertragungseinrichtung zur störgeschützten Übertragung von Informationskanälen mit unterschiedlicher Informationsdichte in gestörten Binärkanälen.

Als Ausführungsbeispiel für die Anwendung des Verfahrens nach der Erfindung wird ein PCM2 A2 System vorgestellt. Zur Übertragung der Hauptkennzeichen (Schliefe) und der Signalisierungsinformation steht dort beispielsweise ein 16 kbit-Kanal zur Verfügung (P. Kahl "Decker's Taschenbuch Telekommunikation, ISDN - Das künftige Fernmeldenetz der Deutschen Bundespost", Heidelberg 1985, insbesondere Kap. 4.1, Seiten 111 bis 119; Kap. 4.6, Seiten 164 bis 174). Dieser Übertragungskanal kann in seiner Organisation - 8 Bit parallel - in 500 $\mu$s nicht beeinflußt werden. Die Forderung der maximalen Verzerrung der Hauptkennzeichen HKZ mit 2 ms kann nur erfüllt werden, wenn Einzelfehler in den Hauptkennzeichen HKZ reparierbar und Mehrfachfehler erkennbar sind. Dies ist nur mit einer Minimaldistanz größer als 3 realisierbar. Es läßt sich kein Alphabet finden, mit dem 5 Bit Information mit 3 Bit gesichert werden kann und die Minimaldistanz größer als 2 wird. Durch Sicherung der Hauptkennzeichen mit 3 Bit erhält man eine Minimaldistanz von 3. Die 3 Bit Signalisierungsinformation S1 ... S3 wird ungesichert übertragen und durch eine zeitliche Wichtung durch Mehrfachentscheidung auf der Empfangsseite gesichert, dadurch, daß die Information nur einmal pro Sekunde ausgewertet wird. Damit läßt sich ein Schutz gegen Einzelfehler und Bündelfehler über die Dauer von bis zu 1/2 sec erreichen.

Die Trennung der Informationskanäle und deren Codierung erfolgt nach ihrer Entropie; d.h. der Kanal mit der höchsten Informationsdichte (Bitrate) - Hauptkanal - wird mit einem linearen Blockcode durch Alphabetreduktion auf größte Minimaldistanz gesichert. Wie die Figur zeigt, werden für das dort gezeigte Ausführungsbeispiel zwei Hauptkennzeichen HZK1 und HZK2 mit 3 Sicherungsbits gesichert, so daß insgesamt 5 Bit im sendeseitigen Blockcode-Coder für den Hauptkanal anstehen. Gegenüber einem 5 B - Code wird die Minimaldistanz erhöht, was eine Vergrößerung der Störsicherheit bedeutet. Die 3 Bit Signalisierungsinformation S1 ... S3 wird dem Block-Code-Coder ebenfalls zugeführt, so daß am Ausgang dieses Coders 8 Bit Parallel-Datenströme erscheinen. Die Taktfrequenz des Coders beträgt 2 kHz. Zur Umwandlung der parallelen Datenströme zu einem seriellen 16 kBit/s-Datenstrom für die Übertragung ist ein Parallel/Serienwandler P/S vorgesehen. Empfangsseitig erfolgt eine entsprechende Serienparallel-Rückumsetzung S/P mit einem 16 kHz Takt. Von den 8 Bit Datenströmen werden im Blockcode-Decoder 5 Bit zur Decodierung der blockgesicherten Hauptkennzeichen HKZ1 und HKZ2 verwendet. Die restlichen 3 Bit der Signalisierungskennzeichen S1 ... S3 werden 1 Mal pro Sekunde ausgewertet und zwar im Sinne einer Mehrfach-Entscheidung, beispielsweise nach der Maximum-Likelihood-Methode. Dies entspricht einer zeitlichen Wichtung (Entprellung) der Information. D.h. die Information wird erst als gültig übernommen, wenn sie über eine vorgegebene Zeitdauer einen konstanten Inhalt behält. Ausfälle dieses Übertragungskanals für die Signalisierinformation über größere Zeitspannen (t < 100ms) können so nicht zu Problemen führen. Im Ausführungsbeispiel wird für jedes Signalisierungsbit ein Zähler Z1 bis Z3 organisiert. Diese Zähler Z1 bis Z3 zählen vorwärts, wenn ein erster logischer Wert - hier 1 - übertragen wurde und rückwärts, wenn die Daten eines zweiten logischen Wertes - hier 0 - übertragen wurden. Jeder Zähler nähert sich bezüglich seinem aufsummierten Zählerergebnis A einer festen oberen Zählschranke X, bei der die Information als "1" erkannt wird, wenn dauerhaft eine "1" übertragen wurde. Entsprechend hierzu nähert sich ein Zähler Z1 bis Z3 einer unteren Zählschranke Y, bei der die Information als eine "0" erkannt wird, wenn ständig eine "0" übertragen wurde. Der erreichbare störabstand richtet sich nach dem Zählerumfang bzw. der zulässigen Verzerrung. Mit der oberen Zählschranke Y wird die zeitliche Wichtung, d.h. die Entprellzeit festgelegt.

Nach dem vorgestellten Prinzip lassen sich natürlich mehrere Zusatzkanäle übertragen und auswerten. Für die Auswertung können anstelle der Zähler und Entscheider andere logische Baugruppen, bzw. Schaltwerke verwendet werden.

Die Erfindung ermöglicht die Verbesserung der Störsicherheit des D-Kanal-Protokolls in einem PCM2 A2-System bei Einzelbitfehlern und Bündelbitfehlern.

In einer Ausführungsform nach der Erfindung werden die beiden Hauptkennzeichen HKZ des Kanals mit der größeren Informationsdichte mit drei Sicherungsbits im Blockcode gesichert ( Blocklänge n = 5, Anzahl der Informationsbits m = 2, Prüfbits d = 3). So wird die Minimaldistanz gegenüber einem 8/5-Code (Blocklange n = 8, Anzahl der Informationsbits m = 5, Prüfbits k = 3) erhöht, was eine Vergrößerung der Störsicherheit bedeutet. Folgende Tabelle stellt das Codealphabet dar:

| Codewort 1 | 0 0 1 1 1 | HKZ1=0 | HKZ2=0 |
|------------|-----------|--------|--------|
| Codewort 2 | 0 1 1 0 0 | HKZ1=0 | HKZ2=1 |
| Codewort 3 | 1 0 0 1 0 | HKZ1=1 | HKZ2=0 |
| Codewort 4 | 1 1 0 0 1 | HKZ1=1 | HKZ2=1 |

Eine der möglichen Generatormatrizen für die Minimaldistanz von 3 für einen 5/2 Code ist:

$$G' = \left[ \binom{1}{0} \binom{0}{1} \binom{1}{0} \binom{1}{1} \binom{0}{1} \right]$$

Die daraus resultierende Kontrollmatrix ist

$$H' = \left[ \begin{pmatrix} 1 \\ 1 \\ 0 \end{pmatrix} \begin{pmatrix} 0 \\ 1 \\ 1 \end{pmatrix} \begin{pmatrix} 1 \\ 0 \\ 0 \end{pmatrix} \begin{pmatrix} 0 \\ 1 \\ 0 \end{pmatrix} \begin{pmatrix} 0 \\ 0 \\ 1 \end{pmatrix} \right]$$

Folgende Aufteilung des Übertragungswortes ist beispielsweise anwendbar:
Codebit 1 = HKZ1 = Schleifenbit Teilnehmer 1
Codebit 2 = NKZ1 = Rufinformation 1
Codebit 3 = HKZ2 = Schleifenbit Teilnehmer 2
Codebit 4 = NKZ2 = Rufinformation 2
Codebit 5 = SBT1 = Sicherungsbit 1 = /HKZ3
Codebit 6 = NKZ3 = Rufinformation 3
Codebit 7 = SBT2 = Sicherungsbit 2 = HKZ2
Codebit 8 = SBT3 = Sicherungsbit 3 = /(HKZ1 $\oplus$ HKZ2)

| b1 | b2 | b3 | b4b | b5 | b6 | b7 | b8 |
|------|------|------|------|------|------|------|------|
| HKZ1 | NKZ1 | HKZ2 | NKZ2 | SBT1 | NKZ3 | SBT2 | SBT3 |

Das Verfahren nach der Erfindung läßt sich prinzipiell für verschiedene Codelängen benutzen.

## Patentansprüche

1. Verfahren zur Übertragung digitaler Daten über einen gemeinsamen Übertragungskanal mit einem gesicherten blockcodierten Hauptkanal und mindestens einem Zusatzkanal, dadurch gekennzeichnet, daß die Daten des/der Zusatzkanals/-kanäle ungesichert übertragen werden und daß die Daten des/der Zusatzkanals/-kanäle zum Schutz gegen Übertragungsfehler im Sinne einer Mehrfachentscheidung empfangsseitig ausgewertet werden.

2. Verfahren nach Anspruch 1, dadurch gekennzeichnet, daß die Daten des/der Zusatzkanals/-kanäle zeitlich gewichtet werden und eine Information erst dann als gültig übernommen wird, wenn sie über eine vorgegebene Zeitdauer einen konstanten Inhalt behält.

3. Verfahren nach Anspruch 1 oder 2, dadurch gekennzeichnet, daß die Daten des/der Zusatzkanals/-kanäle gegenüber den Daten des Hauptkanals mit einer niedrigeren Bitrate übertragen werden.

4. Verfahren nach einem der Ansprüche 1 bis 3, dadurch gekennzeichnet, daß die Daten des/der Zusatzkanals/-kanäle bitweise parallel über die/eine vorgegebene Zeitdauer aufsummiert werden und eine Information jeweils dann als gültig übernommen wird, wenn die jeweilige Aufsummierung eine vorgegebene Schranke über- oder unterschreitet.

5. Verfahren nach einem der Ansprüche 1 bis 4, dadurch gekennzeichnet, daß der Hauptkanal als Kanal mit der höchsten Informationsdichte mit einem linearen Blockcode durch Alphabetreduktion auf größte Minimaldistanz gesichert wird.

6. Verfahren nach einem der Ansprüche 1 bis 5, dadurch gekennzeichnet, daß für den Hauptkanal jeweils zwei Hauptkennzeichen (HKZ1, HKZ2) mit drei Sicherungsbits blockgesichert werden und daß zu diesem Datenstrom jeweils drei Bit ungesicherte Signalisierungsinformation parallel aufbereitet werden.

7. Verfahren nach Anspruch 5, dadurch gekennzeichnet, daß die parallelen Datenströme für die Übertragung zu einem seriellen Datenstrom verarbeitet werden.

8. Verfahren nach Anspruch 7, dadurch gekennzeichnet, daß der seriell übertragene Datenstrom empfangsseitig wieder in parallele Datenströme rückgewandelt wird und daß die Daten des Hauptkanals getrennt von den Daten des/der Zusatzkanals/-Kanäle decodiert bzw. der Mehrfachentscheidung unterzogen werden.

9. Verfahren nach einem der Ansprüche 4 bis 8, dadurch gekennzeichnet, daß für die Aufsummierung von Signalisierungsbits Zähler (Z1, Z2, Z3) verwendet werden, die vorwärts zählen, wenn Daten eines ersten logischen Wertes (1) übertragen wurden, und rückwärts zählen, wenn Daten eines zweiten logischen Wertes (o) übertragen wurden.

10. Verfahren nach Anspruch 9, dadurch gekennzeichnet, daß für den Zähler (Z1, Z2, Z3) eine obere und eine untere Zählschranke für die Aufsummierung definiert wird und daß mit der oberen Zählschranke die zeitliche Wichtung, d.h. die Entprellzeit, festgelegt wird.

EP 0 712 223 A2

S3     S2     S1

| A>X=1<br>A<Y=0 | | | A>X=1<br>A<Y=0 | | | A>X=1<br>A<Y=0 | |
|---|---|---|---|---|---|---|---|
| | X | | | X | | | X |
| A | Y | | A | Y | | A | Y |

obere Schranke

untere Schranke

n       n       n

Counter    Counter    Counter

2kHz   up/down    2kHz   up/down    2kHz   up/down

Z1      Z2      Z3

S1..S3

**Blockcode-Coder**

HKZ 1 ——→ | 5Bit |
HKZ 2 ——→ | 8Bit |

2kHz

**Blockcode-Decoder**

| 5Bit | ——→ HKZ 1
| 8Bit | ——→ HKZ 2

2kHz

8

| P |
| S |

16kBit/s

8

16kHz | P |
| S |

16kBit/s

Bündel-fehler     Einzel-fehler

Transmitter       gestörter Binärkanal       Receiver